(19) Europäisches Patentamt / European Patent Office / Office européen des brevets

(11) **EP 3 589 533 B1**

(12) **FASCICULE DE BREVET EUROPEEN**

(45) Date de publication et mention
de la délivrance du brevet:
**24.08.2022 Bulletin 2022/34**

(21) Numéro de dépôt: **18701439.4**

(22) Date de dépôt: **19.01.2018**

(51) Classification Internationale des Brevets (IPC):
*B62D 15/02* *(2006.01)*    *B60W 40/072* *(2012.01)*
*B60W 30/12* *(2020.01)*    *B60W 30/02* *(2012.01)*
*B60W 30/095* *(2012.01)*    *B60W 50/00* *(2006.01)*

(52) Classification Coopérative des Brevets (CPC):
**B62D 15/025; B60W 30/02; B60W 30/0953;**
**B60W 30/0956; B60W 30/12; B60W 50/0097;**
B60W 2050/0011; B60W 2050/0012;
B60W 2552/30; B60W 2555/20

(86) Numéro de dépôt international:
**PCT/EP2018/051354**

(87) Numéro de publication internationale:
**WO 2018/157999 (07.09.2018 Gazette 2018/36)**

(54) **DISPOSITIF DE CONTROLE DE TRAJECTOIRE D'UN VEHICULE**

VORRICHTUNG ZUR STEUERUNG DES KURSES EINES FAHRZEUGS

DEVICE FOR CONTROLLING THE TRAJECTORY OF A VEHICLE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **28.02.2017 FR 1751593**

(43) Date de publication de la demande:
**08.01.2020 Bulletin 2020/02**

(73) Titulaire: **Renault s.a.s**
**92100 Boulogne Billancourt (FR)**

(72) Inventeurs:
• **BALESTEROS-TOLOSANA, Iris**
**91400 Orsay (FR)**
• **DAVINS-VALLDAURA, Joan**
**75007 Paris (FR)**
• **DEBORNE, Renaud**
**78150 Le Chesnay (FR)**
• **OLARU, Sorin**
**91100 Gif sur Yvette (FR)**

(74) Mandataire: **Renault Group**
**Renault s.a.s.**
**API : TCR GRA 2 36**
**1, Avenue du Golf**
**78084 Guyancourt Cedex (FR)**

(56) Documents cités:
WO-A1-2010/053408    WO-A1-2011/009009
WO-A1-2014/006327    DE-A1-102007 008 624

## EP 3 589 533 B1

**Description**

Les travaux menant à la présente invention ont bénéficié d'un soutien financier du Fonds de recherche du charbon et de l'acier de la Communauté européenne en vertu de la *convention de subvention* n° 607957.

L'invention concerne de manière générale un dispositif de contrôle en temps réel de trajectoire de véhicule. L'invention concerne plus précisément un dispositif de contrôle latéral pour générer en temps réel une commande de braquage d'un véhicule, notamment d'un véhicule automobile autonome ou à conduite partiellement déléguée, c'est-à-dire d'un véhicule pouvant se déplacer totalement ou partiellement sans conducteur humain.

Des dispositifs ou systèmes de contrôle en temps réel de trajectoire, notamment à partir d'états relatifs au véhicule, sont déjà connus dans de nombreux domaines techniques, y compris dans celui de l'automobile.

Par exemple le brevet EP1074903B1 divulgue un système pour suivre une voie avec détection de marquage de la voie. Un module d'action en chaîne directe produit un terme de conduite de direction basé sur une position de ligne cible à partir d'un processeur graphique. Les éléments divulgués laissent envisager une application de ce système à une voie rectiligne, voire avec des virages à faible courbure sans influence notable sur la dynamique du véhicule. Une application sur une voie avec des virages à forte courbure, comme on peut en rencontrer par exemple sur des routes de montagne peut poser un problème de réactivité dynamique du véhicule pour se maintenir avec souplesse dans la voie.

Par exemple encore le brevet US8751089B2 divulgue un système de commande de suivi de trajectoire pour unité mobile. Le système commande une unité mobile pour suivre un trajet cible décrit par des courbes de forme libre. Si ce type de système peut convenir pour piloter un robot dans un espace sans contrainte de nature à empêcher la liberté de forme des courbes qui conviennent à un trajet cible, il peut poser des problèmes pour un véhicule autonome dont le pilotage ne consiste pas à lui faire suivre un trajet cible mais à le maintenir dans une voie de circulation, quelque soient la forme des courbes imposées par la géométrie de la voie.

L'invention a pour objectif de répondre aux problèmes posés par l'état antérieur de la technique, notamment WO 2014/006327 A1, notamment en termes d'efficacité, de réactivité et de facilité de mise en œuvre. WO 2014/006327 A1 révèle les caractéristiques du préambule de la revendication 1.

Pour atteindre cet objectif, l'invention a pour objet un dispositif de contrôle en temps réel de trajectoire d'un véhicule autonome comprenant un module de contrôle qui produit en temps réel à partir d'un vecteur d'états réel ou estimé à chaque instant de suivi d'une voie par le véhicule se déplaçant à une vitesse actuelle, une première commande de braquage pour stabiliser la trajectoire du véhicule par rapport à la voie. Le dispositif est remarquable en ce qu'il comprend un module anticipateur qui génère une grandeur représentative d'un méta-vecteur de perturbations pour chaque position prédite du véhicule à des instants succédant en quantité donnée à l'instant courant et du vecteur d'états à l'instant courant, et en ce que le module de contrôle produit la première commande de braquage par optimisation quadratique d'une relation entre ladite grandeur représentative générée et un méta-vecteur de commandes successives de braquage pour chaque position prédite du véhicule auxdits instants succédant en quantité donnée à l'instant courant.

Particulièrement, lesdites perturbations sont des courbures de la voie pour chaque position prédite du véhicule.

Particulièrement aussi, ladite grandeur représentative comporte pour chaque position prédite du véhicule auxdits instants succédant en quantité donnée à l'instant courant, au moins un produit du vecteur d'états à l'instant courant par une matrice numérique modélisant une relation dynamique du véhicule et élevée à une puissance égale à un rang de succession de ladite position prédite.

Avantageusement, ladite grandeur représentative comporte pour chaque position prédite du véhicule auxdits instants succédant en quantité donnée à l'instant courant, au moins un produit de facteurs comprenant d'une part une perturbation sur la voie à la position prédite, et d'autre part une matrice numérique modélisant une relation dynamique du véhicule et élevée à une puissance égale à un rang de succession de ladite position prédite.

Particulièrement encore, le dispositif comporte un appareil combinant les propriétés d'une caméra optique et d'un radar pour fournir au moins une géométrie de ligne directrice de la voie sous forme d'un polynôme.

Plus particulièrement le module anticipateur comprend un sous-module de calcul de courbure à partir de la géométrie de ligne directrice médiane de la voie au moyen de la formule :

$$\gamma_{k+i} = \frac{y''(x)}{\left(1 + [y'(x)]^2\right)^{3/2}}.$$

De préférence, la relation entre ladite grandeur représentative générée et le méta-vecteur de commandes successives de braquage, comporte pour chaque produit quadratique d'un état anticipé, une matrice de pondération d'états élémentaires et une matrice de pondération de commande élémentaire.

Notamment, la matrice de pondération d'états élémentaires pour le dernier état anticipé, comporte des coefficients particuliers en ce qu'ils sont associés à une fonction positive décroissante du type Lyapunov, de façon à favoriser une convergence de l'optimisation.

2

Indépendamment des coefficients particuliers de la matrice de pondération d'états élémentaires, le dispositif comprend un module imposant à tout ou partie des commandes élémentaires du méta-vecteur de commandes successives de braquage, de respecter des contraintes de type comprenant au moins une borne supérieure sur les états, sur les commandes et/ou sur les mesures et/ou comprenant au moins une borne inférieure sur les états, sur les commandes et/ou sur les mesures.

Avantageusement encore, le dispositif de contrôle comprend un module imposant des contraintes sur tout ou partie des commandes élémentaires du méta-vecteur de commandes successives de braquage, de type comprenant une borne supérieure et une borne inférieure sur les états, sur les commandes et/ou sur les mesures.

Particulièrement, le module impose de plus des contraintes sur les commandes élémentaires du méta-vecteur de commandes successives de braquage, pour que le dernier vecteur d'état prédit soit dans un polytope qui assure une convergence asymptotique au-delà de l'horizon de prédiction.

D'autres caractéristiques et avantages apparaîtront à la lecture de la description qui suit, en référence aux dessins annexés dans lesquels :

- la figure 1 représente un véhicule auquel l'invention est applicable,
- la figure 2 est un schéma de premier mode de mise en œuvre du dispositif conforme à l'invention,
- la figure 3 est un schéma de deuxième mode de mise en œuvre du dispositif conforme à l'invention,
- la figure 4 est un schéma de troisième mode de mise en œuvre du dispositif conforme à l'invention.

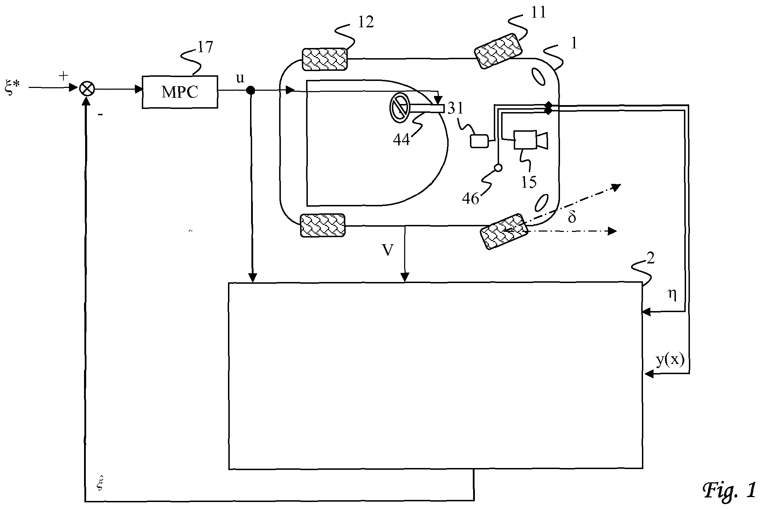

En référence à la figure 1, un véhicule 1 automobile, à traction ou propulsion entrainée par un moteur thermique et/ou électrique (non représenté sur les figures), comporte quatre roues comprenant deux roues avant 11 qui sont de préférence les roues directrices, et deux roues arrière 12. Chaque roue est équipée ou non respectivement d'un capteur de vitesse angulaire instantanée, par exemple de type générateur d'impulsions, permettant de connaître une vitesse actuelle v du véhicule, notamment une vitesse actuelle v longitudinale du véhicule.

Le véhicule 1 comporte une colonne de direction 44 dont la partie haute est équipée ou non d'un volant, ce dernier pouvant devenir inutile pour un véhicule purement autonome, et dont la partie basse agit sur un organe de direction connu en soi qui permet d'orienter les roues avant. La colonne de direction 44 est équipée d'un actionneur piloté par un signal de commande u. L'organe de direction est équipé d'un capteur 46 à la base de la colonne de direction ou à tout autre endroit, par exemple d'une crémaillère agissant sur les roues avant, pour mesurer un angle de braquage $\delta$ effectif des roues avant du véhicule. Le capteur 46 est par exemple un capteur de couple dont la valeur est aisément convertie en angle de braquage.

Le véhicule 1 comporte également un capteur 31 de la vitesse de lacet $\dot{\psi} = \partial\Psi/\partial t$ du véhicule, c'est-à-dire de la vitesse de rotation du véhicule autour de son centre de gravité suivant un axe perpendiculaire au plan de la chaussée sur laquelle circule le véhicule. Le capteur 31 est par exemple un gyromètre situé très proche du centre de gravité (CoG pour center of gravity en anglais) du véhicule. Un appareil 15 de type radar et caméra combinée, c'est-à-dire combinant les propriétés d'une caméra optique et d'un radar, permet de mesurer des coordonnées d'objets $Y_{CAM}$ transversales à un axe médian du véhicule et $X_{CAM}$ selon l'axe médian vers l'avant du véhicule 1.

Telle que connue par ailleurs du fournisseur de l'appareil 15, une fusion des mesures optiques et des mesures radar, permet de détecter pour chaque point de marquage sur la chaussée, la distance x de ce point par rapport à la face avant de l'appareil 15 selon son axe de vision et la distance y de ce même point par rapport à l'axe de vision. Un traitement d'image, hors du cadre de la présente invention, permet à l'appareil 15 de fournir une géométrie y(x) [distance latérale véhicule-ligne] d'au moins une ligne directrice de la voie de circulation du véhicule sous forme d'un polynôme, par exemple de la ligne de délimitation à gauche et de la ligne de délimitation à droite de la voie ou de la ligne médiane de la voie au centre des deux lignes de délimitation. Pour une ligne directrice considérée, le polynôme a par exemple la forme suivante :

$$y = p_{3(t)} \bullet x^3 + p_{2(t)} \bullet x^2 + p_{1(t)} \bullet x + p_{0(t)}.$$

où par exemple le coefficient $p_{0(t)}$ correspond à la distance latérale véhicule-ligne au centre de gravité.

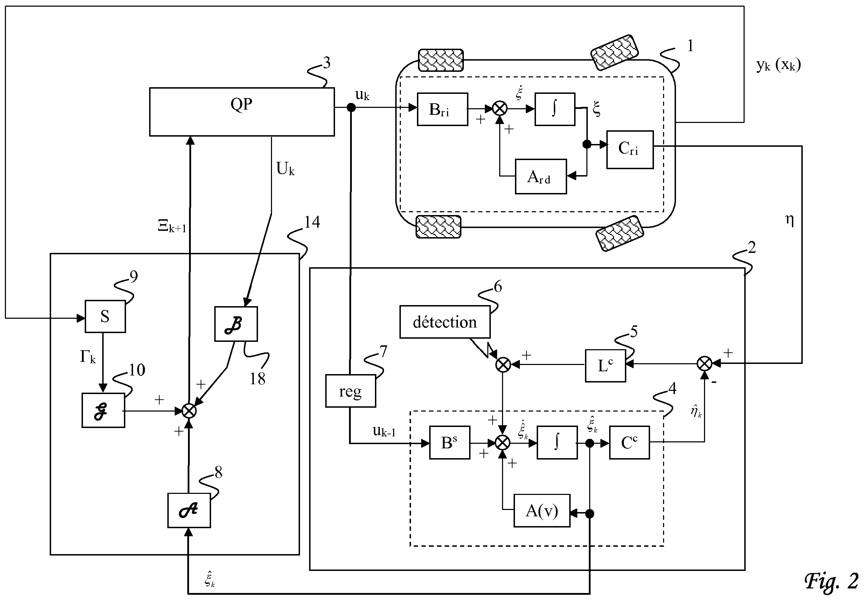

Le véhicule 1 est équipé de manière connue en soi d'un calculateur embarqué (non représenté en tant que tel) permettant de contrôler et de commander différents organes du véhicule. Le calculateur peut recevoir par des connexions, notamment via un bus CAN, Lin, Ethernet automobile ou autre réseau embarqué, des informations en provenance des capteurs de vitesse longitudinale, du capteur 31 de vitesse de lacet, du capteur 46 de l'angle de braquage $\delta$ et de l'appareil 15. Le calculateur embarqué peut aussi commander la colonne de direction 44 en lui communiquant un signal de commande u. Le calculateur embarqué peut héberger en outre, un dispositif contrôleur 17 pour générer le signal de commande u de façon à rendre conforme un vecteur ξ d'états physiques du véhicule à un vecteur d'état de consigne ξ* qui assure un suivi de trajectoire souhaitée par le véhicule 1. Les états physiques du véhicule dépendent de nombreuses données physiques plus ou moins bien maîtrisées qui agissent sur son comportement dynamique. Il est possible de déterminer en temps réel le vecteur ξ_k d'états physiques à chaque instant k lorsque le véhicule est équipé avec au moins un capteur permettant de mesurer chaque état physique. Lorsque le véhicule ne dispose pas d'un capteur pour chaque état contrôlé, le calculateur embarqué héberge un dispositif observateur 2 pour générer en temps réel un vecteur d'états estimés $\hat{\xi}$ de suivi de trajectoire du véhicule 1 se déplaçant à la vitesse v actuelle, à partir de la commande u et d'un vecteur de mesure actuelle η corrélée au vecteur d'états physiques ξ de suivi de trajectoire du véhicule 1, correspondant à la dynamique latérale du véhicule, mesurable et non mesurable en soi, comme expliqué à présent en référence à la figure 2.

Dans le mode de réalisation illustré par la figure 2, on considère un vecteur d'états physiques ξ, effectif du véhicule 1 comprenant au moins deux variables d'état, parmi lesquelles on peut citer par exemple dans un ordre préétabli quelconque mais préférentiellement de manière définitive pour un véhicule donné, une vitesse de lacet effective $\dot{\psi}_{ef} = \partial\Psi/\partial t$ du véhicule, un angle $\Psi_{rel,ef}$ d'écart relatif effectif du véhicule à sa trajectoire idéale et une vitesse latérale effective $\dot{Y}_{CoG,ef} = \partial Y_{CoG}/\partial t$ d'éloignement du centre de gravité du véhicule par rapport à sa trajectoire idéale. L'angle $\Psi_{rel,ef}$ d'écart relatif effectif est l'angle que fait effectivement l'axe médian du véhicule avec la tangente à la trajectoire idéale à chaque instant considéré. La vitesse latérale effective $\dot{Y}_{CoG,ef} = \partial Y_{CoG}/\partial t$ d'éloignement du centre de gravité est la vitesse à laquelle le centre de gravité du véhicule s'éloigne effectivement de la trajectoire idéale, perpendiculaire à la tangente à la trajectoire idéale à l'instant considéré. On entend par trajectoire idéale du véhicule, la ligne médiane de la voie de circulation sur laquelle on souhaite que le véhicule progresse. Le vecteur d'état ξ effectif du véhicule 1 peut comprendre d'autres coordonnées scalaires comme par exemple l'éloignement effectif $Y_{cog,ef}$ du centre de gravité du véhicule par rapport à sa trajectoire idéale, la variation effective $\dot{\delta}_{ef} = \partial\delta/\partial t$ d'angle de braquage des roues du véhicule au cours du temps, et l'angle de braquage effectif $\delta_{ef}$ des roues.

Les variables d'état peuvent avoir une signification indépendante du mode dans lequel fonctionne le véhicule ou une signification propre au mode dans lequel fonctionne le véhicule. La vitesse de lacet qui est la vitesse avec laquelle le véhicule pivote autour d'un axe perpendiculaire au plan de la chaussée, est indépendante du mode de fonctionnement. Il en est de même de la variation effective $\dot{\delta}_{ef} = \partial\delta/\partial t$ d'angle de braquage des roues du véhicule au cours du temps, et de l'angle de braquage effectif $\delta_{ef}$ des roues car ces variables sont liées à l'état des roues elles-mêmes par rapport au châssis du véhicule asservi. Par contre l'éloignement effectif $Y_{cog,ef}$ du centre de gravité du véhicule asservi par rapport à sa trajectoire idéale, est l'écart latéral entre la ligne médiane ou ligne directrice de la voie et le centre de gravité du véhicule asservi sur l'axe perpendiculaire à l'axe du véhicule en mode LCA (Lane Centering Assistance en anglais). La vitesse latérale effective $\dot{Y}_{CoG,ef} = \partial Y_{CoG}/\partial t$ d'éloignement du centre de gravité est la variation temporelle de la variable précédente.

Le vecteur d'état ξ effectif du véhicule 1 peut aussi comprendre des coordonnées scalaires différentes en nombre et/ou en nature selon le mode de fonctionnement du véhicule. En reprenant l'exemple illustratif ci-dessus, une variable d'état facultative $\int -Y_{COG}dt$ peut représenter une intégrale temporelle des écarts du centre de gravité du véhicule asservi par rapport au point de la ligne directrice de la voie sur lequel il devrait être. En fait cette variable d'état ne correspond à aucun état physique réel, elle est plutôt un artifice hérité des asservissements en boucle fermés de type PID, dans lesquels la composante intégrale du gain permet d'obtenir une sortie non nulle de l'amplificateur pour une erreur nulle appliquée à son entrée, avec pour effet technique d'imposer une erreur nulle, ici sur l'éloignement effectif $Y_{cog,ef}$ du centre de gravité du véhicule par rapport à la ligne médiane de la voie de circulation.

A ce vecteur ξ d'état effectif du véhicule 1 correspond un vecteur ξ* d'état de référence que l'on souhaite être atteint à chaque instant de roulage du véhicule asservi. Par exemple aux coordonnées $\dot{\psi}_{ef}$, $\Psi_{rel,ef}$, $\dot{Y}_{CoG,ef}$, $Y_{CoG,ef}$ du vecteur d'état ξ correspondent des coordonnées $\dot{\psi}_{ref}$, $\Psi_{ref}$, $\dot{Y}_{CoG,ref}$, $Y_{CoG,ref}$ du vecteur d'état ξ* de valeurs nulles car on souhaite bien entendu une absence d'écart entre la trajectoire effective du véhicule asservi et sa trajectoire idéale, par exemple, le centre de la voie.

Le dispositif observateur 2 est particulièrement utile lorsque le vecteur ξ d'états effectif du véhicule 1 est inconnu parce que l'état interne du véhicule asservi, régi par les lois naturelles de la physique, comporte tout ou partie des variables d'état inaccessibles et non mesurables.

On rappelle que les lois connues de la physique posent qu'un vecteur $\dot{\xi}$ d'évolution temporelle du vecteur $\xi$ d'états du système physique constitué par le véhicule 1, est lié au vecteur $\xi$ d'états par une relation dynamique $A_{rd}$ qui, en absence de perturbation extérieure, tend généralement à amener l'état du véhicule à un état final stable. L'état final stable du véhicule n'étant pas nécessairement celui que l'on cherche à atteindre, le but de l'invention est de produire une commande u qui perturbe en permanence le système pour maintenir le vecteur $\xi$ d'états effectif conforme au vecteur $\xi^*$ d'états de référence. La perturbation ainsi provoquée sur le vecteur $\dot{\xi}$ d'évolution temporelle, est liée à la commande u par une relation invasive $B_{ri}$, elle aussi régie par les lois de la physique. D'autres perturbations extérieures, de nature globalement inconnues, agissant aussi sur le système physique constitué par le véhicule 1, on emploi un mécanisme d'asservissement à contre-réaction dans lequel le dispositif observateur 2 a pour but de générer en temps réel, à chaque instant courant indicé k, un vecteur $\hat{\xi}_k$ d'états estimé représentant le plus fidèlement possible le vecteur $\xi$ d'états effectif.

Pour atteindre son but, le dispositif observateur 2 comprend un module 4 qui modélise le système physique constitué par le véhicule 1, notamment en termes de suivi de trajectoire. Le module 4 comporte une matrice numérique calculée A(v), notamment en fonction de la vitesse v du véhicule, et modélisant la relation dynamique $A_{rd}$ et une matrice numérique $B^s$ représentative de la relation invasive $B_{ri}$.

La matrice numérique A(v) peut avoir différentes formes, chacune adaptée à un mode de fonctionnement du véhicule. La forme de la matrice numérique A(v) est essentiellement liée à la définition du vecteur $\xi$ d'état du véhicule 1 et à la relation dynamique appliquée. L'exemple de forme exposé ci-dessous, se base sur le modèle bicyclette bien connu dans le domaine technique considéré, comme l'illustrent de nombreux documents antérieurs tels que FR2925005 ou WO2012084465.

$$\xi = \begin{pmatrix} \dot{\psi} \\ \psi_{rel} \\ \dot{Y}_{CoG} \\ Y_{CoG} \\ \dot{\delta} \\ \delta \\ \int -Y_{CoG}dt \end{pmatrix}$$

L'exemple considéré ici est celui du mode LCA, pour lequel par exemple au vecteur d'état correspond la matrice numérique A(v) donnée par la formule 101 suivante :

$$A(v) = \begin{pmatrix} a_{11}(v) & a_{12} & a_{13}(v) & 0 & 0 & a_{16} & 0 \\ 1 & 0 & 0 & 0 & 0 & 0 & 0 \\ a_{31}(v) & a_{32} & a_{33}(v) & 0 & 0 & a_{36} & 0 \\ 0 & 0 & 1 & 0 & 0 & 0 & 0 \\ 0 & 0 & 0 & 0 & a_{55} & a_{56} & 0 \\ 0 & 0 & 0 & 0 & 1 & 0 & 0 \\ 0 & 0 & 0 & -1 & 0 & 0 & 0 \end{pmatrix}$$

Dans laquelle certains coefficients sont variables et d'autres sont constants au cours d'une même séquence de roulage.

Les coefficients variables sont essentiellement ceux qui dépendent d'une vitesse, notamment de la vitesse v longitudinale du véhicule. Pour s'adapter aux variations de vitesse, les coefficients variables sont recalculés en temps réel en lisant d'une part la vitesse v du véhicule 1, notamment la vitesse v longitudinale généralement accessible sur le réseau embarqué (type Bus CAN, LIN, Ethernet automobile ou autre) et d'autre part des paramètres généralement accessibles en mémoire, au moyen des formules 102 à 105 dans l'ordre suivant :

$$a_{11}(v) = \frac{-(c_r l_r^2 + c_f l_f^2)}{I_z v}$$

$$a_{13}(v) = \frac{(c_r l_r - c_f l_f)}{I_z v}$$

$$a_{31}(v) = \frac{(c_r l_r - c_f l_f)}{Mv}$$

$$a_{33}(v) = \frac{-(c_r + c_f)}{Mv}$$

Dans lesquelles les paramètres $c_r$, $c_f$, $l_r$, $l_f$, $I_z$, M quantifient de manière connue en soi par ailleurs (cf. dépôts FR1255068, FR1255188, ou FR12563339) chacun respectivement la rigidité de dérive des roues arrières 12 et la rigidité de dérive des roues avant 11 obtenues auprès du fournisseur de pneumatique des roues ou au moyen d'essais de roulage sur circuit, la distance de l'axe des roues arrière et la distance de l'axe des roues avant par rapport au centre de gravité CoG du véhicule 1, le moment d'inertie du véhicule autour de la perpendiculaire au plan passant par les axes de roues avant et arrière, et enfin la masse du véhicule.

Les coefficients constants au cours d'une séquence de roulage peuvent être précalculés lors de la conception du véhicule puis stockés en mémoire de calculateur embarqué. Ils sont déterminés par les formules 106 à 111 dans l'ordre suivant :

$$a_{12} = \frac{(c_f l_f - c_r l_r)}{I_z}$$

$$a_{16} = \frac{c_f l_f}{I_z}$$

$$a_{32} = \frac{(c_f + c_r)}{M}$$

$$a_{36} = \frac{c_f}{M}$$

$$a_{55} = -2\mu\omega$$

$$a_{56} = -\omega^2$$

Dans lesquelles d'une part $\mu$ et $\omega$ désignent respectivement un coefficient d'amortissement et une pulsation propre de la fonction de transfert de la commande de braquage des roues qui modélise la dynamique de la colonne de direction.

Les coefficients constants au cours d'une séquence de roulage peuvent aussi être calculés à chaque démarrage du véhicule pour tenir compte d'une masse M et d'un moment d'inertie $I_z$ qui peut être différents à chaque démarrage en fonction du nombre de passagers et du chargement. Les variations de ces paramètres, par exemple provoquées par la consommation de carburant ou un passager descendant du véhicule en cours de route, sont généralement peu significatives.

Les coefficients unitaires existent sur la ligne correspondant à la dérivée temporelle d'une variable d'état qui est elle-même une variable d'état de rang égal à celui de la colonne de la matrice.

Les autres coefficients sont nuls, à l'exception de la dernière colonne où ils sont tous nuls et de la dernière ligne où seul le coefficient médian n'est pas nul mais égal à -1 pour reproduire artificiellement une contre réaction d'asservissement linéaire classique type PID.

Le nombre de colonnes de la matrice est égal au nombre de coordonnées du vecteur d'état et le nombre de lignes est égal au nombre de coordonnées du vecteur de variation temporelle d'état, c'est-à-dire égal au nombre de lignes. On comprendra que la matrice numérique A(v) peut comporter des nombres de lignes et de colonnes différents de ceux des exemples ci-dessus, notamment supérieur si le besoin se fait ressentir de considérer une variable d'état supplémentaire ou inférieure si on considère inutile une variable d'état.

La matrice numérique $B^s$ représentative de la relation invasive $B_{ri}$, est adaptée au mode de commande du véhicule et de prise en compte de facteurs extérieurs. La forme de la matrice numérique $B^s$ est essentiellement liée au vecteur $\xi$ d'état dont le nombre de coordonnées fixe le nombre de lignes et aux interactions avec le système dont la quantité fixe le nombre de colonnes. L'exemple principal de forme exposée ci-dessous, correspond à l'exemple exposé ci-dessus.

Pour le mode LCA, la matrice numérique $B^s$ est donnée par la formule 112 suivante :

$$B^s = \begin{pmatrix} 0 \\ 0 \\ 0 \\ 0 \\ b_{51} \\ 0 \\ 0 \end{pmatrix}$$

Dans laquelle l'unique colonne est ici associée à la première perturbation qui est la commande u de braquage. Le coefficient $b_{51}$ est ici encore égal au carré de la pulsation propre $\omega$ de la fonction de transfert de la commande de braquage des roues.

Pour modéliser le véhicule 1, le module 4 reçoit la commande $u_{k-1}$ à chaque instant discret d'échantillonnage k de façon à générer le vecteur $\hat{\xi}_k$, d'état estimé en reproduisant les équations de la dynamique au moyen des matrices numériques A(v) et $B^s$ intervenant dans les formules 113 et 114 respectivement:

$$\hat{\xi} = \int \dot{\hat{\xi}}\, dt$$

$$\dot{\hat{\xi}} = A(v)\hat{\xi} + B^s u_{k-1}$$

Plusieurs conditions devraient être satisfaites pour que le vecteur $\hat{\xi}$ d'état estimé reproduise fidèlement le vecteur $\xi$ d'état physique du véhicule.

Dans la formule 113 qui est une intégrale par rapport au temps, il faudrait qu'à un instant initial, le vecteur $\hat{\xi}$ d'état estimé soit égal au vecteur $\xi$ d'états physiques du véhicule.

Dans la formule 114, il faudrait que les matrices numériques A(v) et $B^s$ modélisent parfaitement la relation dynamique $A_{rd}$ et la relation invasive $B_{ri}$ qui impactent réellement le véhicule.

On conçoit bien que ces conditions ne peuvent pas être satisfaites pour de nombreux motifs tels que l'exactitude des paramètres qui qualifient le véhicule alors qu'ils sont soumis aux dispersions de fabrication et au vieillissement d'usage, les perturbations imprévues et bien d'autres motifs connus ou inconnus sauf à équiper bien entendu le véhicule avec des capteurs en quantité suffisante pour mesurer chaque état réel du véhicule.

Pour réduire l'écart entre le vecteur $\hat{\xi}$ d'état estimé qui est calculé, et le vecteur $\xi$ d'état physique du véhicule au même instant k qui est inconnu, l'observateur 2 reçoit sur une deuxième entrée, un vecteur $\eta$ de mesures actuelles qui sont représentatives de l'état du véhicule. Le vecteur $\eta$ de mesures actuelles, est corrélé au vecteur $\xi$ d'états physiques par une relation instrumentale $C_{ri}$ qui dépend de la configuration du vecteur d'état, c'est-à-dire du mode de fonctionnement du véhicule, et des capteurs de mesure qui équipent le véhicule.

Reprenant l'exemple pour le mode de fonctionnement LCA, le vecteur $\eta$ de mesure actuelle comporte cinq composantes qui sont la vitesse de lacet $\dot{\Psi}$ telle qu'elle est mesurée par le capteur 31, l'angle $\Psi_{rel}$ d'écart relatif tel qu'il est mesuré par l'appareil 15 visant une ligne médiane de la voie de circulation, l'éloignement radial $Y_{CoG}$ du centre de gravité par rapport à la ligne médiane de la voie de circulation tel que cet éloignement est obtenu à partir de l'appareil 15 ou du calculateur embarqué, l'angle $\delta$ de braquage des roues 11 tel qu'il est mesuré par le capteur 46 et l'accumulation $\int Y_{CoG}\, dt$ au cours du temps de l'opposé de l'éloignement $Y_{CoG}$ du centre de gravité fourni par l'appareil 15. En assimilant la durée dt à la période d'échantillonnage pour chaque instant k, cette pseudo mesure est obtenue par la formule 115 très simple :

$$\left[\int Y_{CoG} dt\right]_k = \left[\int Y_{CoG} dt\right]_{k-1} + \left[Y_{CoG}\right]_k \text{ initialisée à zéro.}$$

La relation instrumentale $C_{ri}$ est approchée dans le module 4 par une matrice numérique $C^c$ pour générer un vecteur $\hat{\eta}_k$ de mesure estimée à partir du vecteur $\hat{\xi}_k$ d'état estimé pour le mode de fonctionnement considéré.

$$\eta = \begin{pmatrix} \dot{\psi} \\ \psi_{rel} \\ Y_{CoG} \\ \delta \\ \int - Y_{CoG} dt \end{pmatrix}$$

Dans le mode de fonctionnement LCA, par exemple au vecteur de mesures                    correspond la matrice numérique $C^c$ donnée de préférence par la formule 116 suivante :

$$C^C = \begin{bmatrix} 1 & 0 & 0 & 0 & 0 & 0 & 0 \\ 0 & 1 & 0 & 0 & 0 & 0 & 0 \\ 0 & 0 & 0 & 1 & 0 & 0 & 0 \\ 0 & 0 & 0 & 0 & 0 & 1 & 0 \\ 0 & 0 & 0 & 0 & 0 & 0 & 1 \end{bmatrix}$$

Dans laquelle les coefficients non nuls $c_{11}$, $c_{22}$, $c_{34}$, $c_{46}$, $c_{57}$, sont constants et unitaires car les mesures considérées font partie des variables d'état dans le cas particulier de l'exemple illustratif.

Le module 4 calcule alors le vecteur de mesure estimé $\hat{\eta}_k$ en multipliant en temps réel le vecteur $\hat{\xi}_k$ d'état estimé par la matrice $C^c$ à chaque instant d'indice k.

Quel que soit le mode de fonctionnement du véhicule, un module 5 de gain d'estimation (parfois nommé gain de Kalman) a pour fonction de corriger la dérivée temporelle $\dot{\hat{\xi}}$ du vecteur d'état pour que le vecteur de mesure estimé $\hat{\eta}$ à partir du vecteur $\hat{\xi}$ d'état estimé coïncide en régime établi avec le vecteur $\eta$ de mesure réelle, de sorte que le vecteur $\hat{\xi}$ d'état estimé coïncide ainsi avec le vecteur $\xi$ d'état physique de suivi de trajectoire du véhicule 1. Pour ce faire, le module 5 ajuste en temps réel la variation temporelle $\dot{\hat{\xi}}$ de vecteur d'état estimé $\hat{\xi}$ de façon à réduire un écart de stabilisation entre le vecteur de mesure actuelle $\eta$ et le vecteur de mesure estimée $\hat{\eta}$ en multipliant l'écart de stabilisation par une matrice de gain de correction $L^c$.

L'écart de stabilisation entre les deux vecteurs de mesure $\eta$ et $\hat{\eta}$, étant un vecteur de dimension égale à celle des vecteurs de mesure et la correction à ajouter à la variation temporelle $\dot{\hat{\xi}}$ de vecteur d'état estimé, étant un vecteur de dimension égale à celle des vecteurs d'état, la matrice $L^c$ comporte un nombre de lignes égal au nombre de coordonnées du vecteur d'état et un nombre de colonnes égal au nombre de coordonnées du vecteur de mesure.

Ainsi, le dispositif observateur 2 peut se comporter comme un observateur de Kalman défini par l'équation de formule 117:

$$\dot{\hat{\xi}} = A^c \hat{\xi} + B^s u_{st} + L^c (\eta - C^c \hat{\xi})$$

La matrice $L^c$ correspond à la matrice des gains de l'observateur de Kalman, sans qu'il apparaisse nécessaire ici de développer plus en détail son obtention qui est connue par ailleurs.

L'observateur de Kalman décrit ci-dessus, l'est essentiellement à titre illustratif pour mieux comprendre la mise en œuvre de l'invention mais d'autres observateurs peuvent être utilisés comme par exemple des observateurs à grand gain, des observateurs par mode glissants, des observateurs de type Kalman étendu, les observateurs de Luenberger ou d'autres filtres de type bayésiens pour lesquels l'homme du métier devrait savoir sans peine transposer l'enseignement ici prodigué.

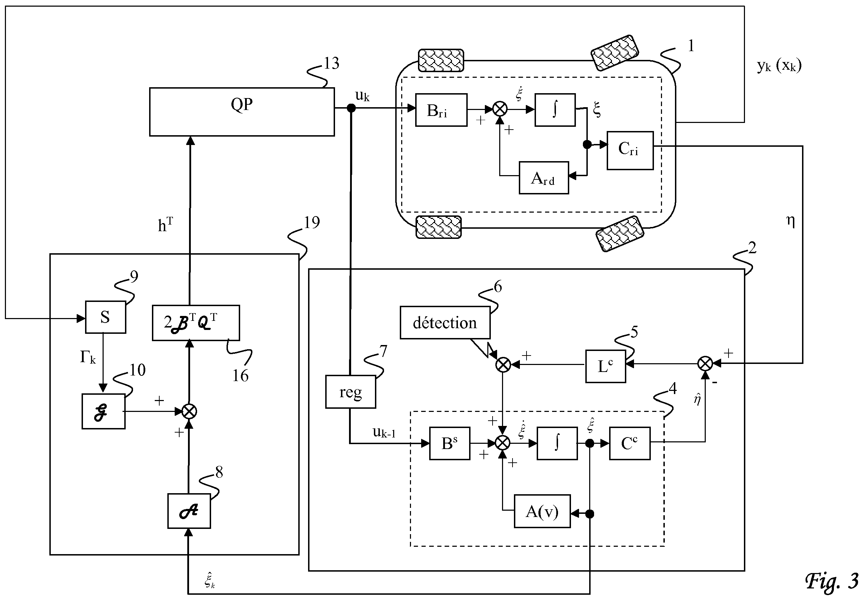

Le vecteur d'état estimé $\hat{\xi}$ ainsi généré par le module 2 est communiqué à un module 14 dans le mode de réalisation didactique illustré par la figure 2 ou à un module 19 dans le mode de réalisation préférée illustré par la figure 3. Le module 14 et le module 19 ont en commun de générer une grandeur vectorielle qui prend en compte le vecteur d'état estimé $\hat{\xi}$ à l'instant k et les courbures $\gamma_{k+i}$ aux endroits de la voie attendus du véhicule à chaque instant k+i futur de déplacement du véhicule, i variant de 1 à N. Le nombre entier N désigne ainsi la quantité d'échantillonnages à venir qui, généralement effectués avec une période constante, établit une fenêtre temporelle nommée « horizon de prédiction » dans laquelle est effectuée la prédiction. Sa valeur est paramétrable de manière à pouvoir l'ajuster en phase de mise au point d'un véhicule d'essai, pour être ensuite reportée dans les véhicules de série. On choisit généralement le nombre N pour obtenir une fenêtre temporelle de l'ordre de 1 à 5 secondes, typiquement correspondant à une distance de sécurité avant collision avec un obstacle. A partir de ce bloc, une discrétisation des matrices du système est fait, cette discrétisation peut être faite par des méthodes de discrétisation d'Euler basée sur Taylor séries ou des méthodes de discrétisation exacte, par exemple.

Il est bien entendu que si on dispose d'un vecteur $\xi_k$ d'états réels du véhicule par rapport à la voie à l'instant k, c'est le vecteur $\xi_k$ d'états réels qui est communiqué au module 14 dans le mode de réalisation didactique illustré par la figure 2 ou au module 19 dans le mode de réalisation préférée illustré par la figure 3. Le module 2 n'est alors plus utile.

La description explique à présent comment le module 14 ou 19 anticipateur génère une grandeur représentative des courbures de la voie pour chaque position prédite de rang de succession i du véhicule 1 à des instants succédant en quantité donnée N à l'instant k courant et du vecteur d'état estimé $\hat{\xi}_k$ à l'instant k courant.

La grandeur vectorielle générée par le module 14 est un méta vecteur d'état $\Xi_{k+1} = (\hat{\xi}_{k+i})_{i=1}^N$ comprenant les N états estimés prédits à la suite de l'état estimé $\hat{\xi}_k$ ou de l'état réel $\xi_k$. Considérant n le nombre d'états élémentaires du système, c'est-à-dire le nombre de coordonnées du vecteur d'état estimé $\hat{\xi}_k$ ou réel $\xi_k$ et N le nombre de courbures de voie anticipées à l'avant du véhicule, le vecteur $\Xi_{k+1} = (\hat{\xi}_{k+i})_{i=1}^N$ comporte N fois n composantes estimées pour être prédites aux instants futurs.

On peut le définir de la manière suivante :

Pour l'instant k+1, on ne dispose pas encore à l'instant k de vecteur de mesure $\eta_{k+1}$, mais si on connaît la courbure de la voie $\gamma_k$ qui agit comme une perturbation, on peut écrire la formule 118 :

$$\hat{\xi}_{k+1} = A(v)\hat{\xi}_k + B^S u_k + G(v)\gamma_k$$

Où G(v) est une matrice à une colonne et à n lignes, chacune correspondant à une coordonnée d'état du vecteur d'état $\xi_k$.

Dans la colonne de la matrice G(v), seuls deux coefficients $g_2$ et $g_3$ sont non nuls en considérant que la courbure $\gamma_k$ agit directement sur l'angle $\Psi_{rel,ef}$ d'écart relatif effectif du véhicule à sa trajectoire idéale et sur la vitesse latérale effective $\dot{Y}_{CoG,ef} = \partial Y_{CoG} / \partial t$ d'éloignement du centre de gravité du véhicule par rapport à sa trajectoire idéale. Le coefficient $g_2$ est égal à l'opposé de la vitesse longitudinale v de véhicule et le coefficient $g_3$ est égal à l'opposé du carré de la vitesse longitudinale v de véhicule.

Par extrapolation si on connaît les courbures suivantes $\gamma_{k+i}$ de la voie, les coordonnées du vecteur $\Xi_{k+1} = (\hat{\xi}_{k+i})_{i=1}^N$ s'expriment alors en fonction de celles du vecteur d'indice k de la manière suivante en faisant varier i de 1 à N :

Pour i=1 :

$$\hat{\xi}_{k+1} = A(v)\hat{\xi}_k + B^S u_k + G(v)\gamma_k$$

Pour i=2 :

$$\hat{\xi}_{k+2} = A(v)\hat{\xi}_{k+1} + B^S u_{k+1} + G(v)\gamma_{k+1} = A(v)(A(v)\hat{\xi}_k + B^S u_k + G(v)\gamma_k) + B^S u_{k+1} + G(v)\gamma_{k+1}$$

$$\hat{\xi}_{k+i} = A(v)^i \hat{\xi}_k + A(v) \cdot B^S u_k + A(v) \cdot G(v)\gamma_k + Bu_{k-1+i} + G\gamma_{k-1+i}$$

Pour i=3 :

$$\hat{\xi}_{k+i} = A(v)^i \hat{\xi}_k + A(v)^{i-1}(B^S u_k + G(v)\gamma_k) + A(v)^{i-2}(B^S u_{k-2+i} + G(v)\gamma_{k-2+i}) + Bu_{k-3+i} + G\gamma_{k-3+i}$$

On voit apparaître une formule 119 du type :

$$\hat{\xi}_{k+i} = A(v)^i \hat{\xi}_k + \sum_{j=1}^{i} A(v)^{i-j} \cdot B^S u_{k+i-j} + \sum_{j=1}^{i} A(v)^{i-j} \cdot G(v)\gamma_{k+i-j}$$

Ou sous forme matricielle compacte en définissant les méta-matrices et méta-vecteurs suivants :

$A = \left[ A(v)^i \right]_{i=1}^{N}$ est une méta-matrice à N fois n lignes et à n colonnes. En d'autres termes, les n premières lignes de la méta-matrice A retranscrivent la matrice A(v) et les n dernières lignes de la méta-matrice A retranscrivent la matrice $A(v)^N$. Les lignes intermédiaires n(i-1)+1 à ni de la méta-matrice A, quant à elles retranscrivent la matrice $A(v)^i$. Ceci revient à considérer la vitesse v dont dépend à chaque instant la matrice calculée A(v), constante sur les N instants anticipés de l'horizon de prédiction. La valeur de la vitesse v sera bien entendu rafraîchie à l'itération suivante de calcul. Si les moyens de calcul le permettent, on peut aussi prédire une variation de vitesse en fonction d'une connaissance

$B = \left[ A(v)^{i-j} \cdot B^S \right]_{\substack{i=1 \\ j \le i}}^{NxN}$

d'accélération ou de décélération. est une méta-matrice à N fois n lignes et de manière la plus générale N fois $n_c$ colonnes, où $n_c$ est le nombre de commandes du système. Dans le cas du système LCA avec pour seule commande celle de l'angle de braquage, $n_c$ =1. En d'autres termes, les n premières lignes de la première colonne de la méta-matrice B retranscrivent le produit matriciel $A(v)^0 \cdot B^S$, c'est-à-dire la matrice $B^s$, et les n premières lignes des colonnes suivantes sont à coefficients nuls, de même que les n dernières lignes de la dernière colonne de la méta-matrice B retranscrivent le produit matriciel $A(v)^0 \cdot B^S$. Les lignes intermédiaires n(i-1)+1 à n(i-1)+n d'une $j^{ième}$ colonne de la méta-matrice B, j étant compris entre 1 et i, quant à elles retranscrivent le produit matriciel $A(v)^{i-j} \cdot B^S$, les mêmes lignes sur les colonnes suivantes étant à coefficients nuls. $U_k = (u_{k+i})_{i=1}^{N}$ est un méta-vecteur à N lignes qui répertorie les N commandes suivantes prévues d'être appliquées pour une évolution d'état du véhicule conforme à celle estimable

$G = \left[ A(v)^{i-j} \cdot G \right]_{\substack{i=1 \\ j \le i}}^{NxN}$

à partir de l'état courant. est une méta-matrice à N fois n lignes et N colonnes. En d'autres termes, les n premières lignes de la première colonne de la méta-matrice G retranscrivent le produit matriciel $A(v)^0 \cdot G(v)$, c'est-à-dire la matrice G(v), et les n premières lignes des colonnes suivantes sont à coefficients nuls, de même que les n dernières lignes de la dernière colonne de la méta-matrice G retranscrivent le produit matriciel $A(v)^0 \cdot G(v)$. Les lignes intermédiaires n(i-1)+1 à n(il)+n d'une $j^{ième}$ colonne de la méta-matrice G, j étant compris entre 1 et i, quant à elles retranscrivent le produit matriciel $A(v)^{i-j} \cdot G(v)$, les mêmes lignes sur les colonnes suivantes étant à coefficients nuls.

$\Gamma_k = (\gamma_{k+i})_{i=1}^{N}$ est un méta-vecteur à N lignes qui répertorie les courbures de la voie ou en d'autres termes de trajectoire idéale du véhicule sur un horizon de prédiction de N instants futurs d'échantillonnage. Pour obtenir le méta-vecteur $\Gamma_k$, le module 14 comprend un sous-module de calcul 9 qui peut générer le méta-vecteur $\Gamma_k$ de courbures anticipées de la voie de différentes manières.

Dans un premier mode de prédiction dans lequel les courbures anticipées de la voie sont celles imposées par la chaussée au véhicule pour les k instants futurs en supposant une vitesse constante du véhicule, le sous-module de calcul 9 reçoit le polynôme $y_k(x_k)$ donné à l'instant courant k de traitement par l'appareil 15 décrit ci-dessus en référence à la figure 1. Le sous-module de calcul 9 reçoit alors de l'appareil 15 le polynôme $y_k(x_k)$ qui donne la géométrie de la ligne directrice de la voie de circulation pour chaque point à la distance $x_{k+1}, x_{k+i}, x_{k+N}$, à l'avant du véhicule, généralement sous forme d'un vecteur $(p_0, p_1, p_2, p_3)^T$ dont les coordonnées correspondent aux coefficients du polynôme. Le sous-module de calcul 9 calcule alors la courbure $\gamma_{k+i}$ au moyen de la formule 120 ci-dessous :

$$\gamma_{k+i} = \frac{y''(x_{k+i})}{\left(1+[y'(x_{k+i})]^2\right)^{3/2}}$$

Où la distance de la position future du véhicule $x_{k+i}$ à l'avant du véhicule est elle-même calculable en temps réel à partir de la vitesse v, par exemple en première approximation au moyen de la formule 121 ci-dessous :

$$x_{k+i} = i \cdot v \cdot Ts$$

Où Ts est la période d'échantillonnage et/ou de traitement numérique. D'autres formules plus élaborées peuvent facilement être envisagées par l'homme du métier, par exemple en tenant compte d'une projection de la trajectoire sur la ligne droite à l'avant du véhicule.

Si le polynôme est de degré 3 comme évoqué ci-dessus, la dérivée première est donnée de manière simple par la formule 122 ci-dessous :

$$y'(x) = 3p_3x^2 + 2p_2x + p_1$$

De même, la dérivée seconde est donnée par la formule simple :

$$y''(x) = 6p_3x + 2p_2$$

Chaque courbure $\gamma_{k+i}$ peut ainsi facilement être calculée en temps réel au moyen de la formule 123 ci-dessous :

$$\gamma_{k+i} = \frac{6p_3x_{k+i} + 2p_2}{\left(1+[3p_3x_{k+i}^2 + 2p_2x_{k+i} + p_1]^2\right)^{3/2}}$$

Dans le premier mode de prédiction dans lequel les courbures anticipées de la voie sont celles imposées par la chaussée au véhicule pour les k instants futurs, une alternative de mise en œuvre consiste à agencer le sous-module de calcul 9 pour accéder à une cartographie de système routier suffisamment précise, stockée en mémoire embarquée ou téléchargée en temps réel, combinée à un système S de positionnement par satellite à haute précision, par exemple de type GALILEO, de manière à déduire les courbures de voie de circulation à partir de ladite cartographie et du positionnement du véhicule.

Dans un deuxième mode de prédiction dans lequel les courbures prédites de trajectoire, sont celles générées par un système de calcul de trajectoire en mode autonome, par exemple pour changer de voie ou de direction, pour éviter un obstacle ou pour toute autre raison, le sous-module de calcul 9 reçoit une équation descriptive de la trajectoire idéale en mode autonome en provenance de ce système de calcul. Les courbures $\gamma_{k+i}$ à appliquer à la trajectoire peuvent par exemple concerner celles d'un écart à effectuer par le véhicule pour éviter un obstacle ou pour changer de voie.

Ainsi, le dispositif de contrôle de l'invention peut anticiper l'annonce d'un virage à la manière d'un conducteur qui regarde la route devant le véhicule pour amorcer un virage, changer de voie ou de direction, éviter un obstacle ou tout autre chose, plutôt que de guider le véhicule comme s'il était sur un rail.

Avantageusement la distance x varie en fonction de la vitesse v actuelle du véhicule. A titre purement illustratif et non limitatif, on peut envisager les distances x égales au produit de la vitesse v multipliée par des temps de réponse donnés à valeurs fixes ou à valeurs elles-mêmes fonction de la vitesse. Ces temps de réponse peuvent eux aussi être paramétrables pour permettre de les ajuster au cours des essais du véhicule.

Le méta-vecteur $\Gamma_k = (\gamma_{k+i})_{i=1}^{N}$ généré par le sous-module de calcul 9 est transmis à un sous-module de multiplication 10 du méta-vecteur $\Gamma_k$ par la méta-matrice G.

Les courbures anticipées de la voie constituent une succession de perturbations imposées par l'environnement du véhicule ou par tout autre événement de nature involontaire, mais prédictibles sur l'horizon d'anticipation considéré. D'autres perturbations prédictibles peuvent être prises en compte par le dispositif selon l'invention. Par exemple le vent latéral communiqué par une station météo ou un capteur dédié du véhicule, notamment au passage d'un viaduc franchissant une vallée. Par exemple encore un déséquilibrage de la pression des pneus ou une présence de verglas sur la chaussée. On peut ainsi prévoir le dispositif selon l'invention pour anticiper une succession de perturbations constantes ou variables sur un horizon donné de prédiction.

Dans le mode de réalisation didactique illustré par la figure 2, le module 14 comprend un sous-module 18 dont la sortie est additionnée à la sortie du sous-module 8 et à la sortie du sous-module 10 dans le but de transmettre au module 3 le méta-vecteur d'état ou vecteur de vecteurs d'états donné par la formule 124 ci-dessous:

$$\Xi_{k+1} = A\ \hat{\xi}_k + B\ U_k + G\ \Gamma_k$$

Dans la formule 124, le méta-vecteur $U_k$ est idéalement le vecteur des N commandes $u_k$, $u_{k+i}$, i variant de 1 à N-1 optimisées telles qu'elles sont calculées par le module 3 à partir du méta-vecteur $\Xi_{k+1}$ d'état transmis par le module 14 au module 3. Dans un traitement numérique séquentiel, on peut initialiser le méta-vecteur $U_k$ au méta-vecteur $U_{k-1}$ de l'instant de traitement précédent k-1. Cette façon de faire permet à l'algorithme d'optimisation exécuté par le module 3 de converger plus rapidement.

Le méta-vecteur $U_k$ d'anticipation de commandes, a pour valeur optimale celle calculée par le module 3 à partir du méta-vecteur $\Xi_{k+1}$ d'anticipation d'états, de la manière expliquée à présent.

Le module 3 héberge une première méta-fonction de coût $\mathcal{J}_1$ donnée par la formule 125 ci-dessous:

$$\mathcal{J}_1 = \Xi_{k+1}^{T} Q\ \Xi_{k+1} +\ U_k^{T} R\ U_k$$

Dans laquelle le membre de gauche de la méta-fonction de coût $\mathcal{J}_1$ est une valeur scalaire à minimiser, et le membre de droite et une somme de deux termes d'optimisation quadratique. On reconnaît dans le premier terme du membre de droite le méta-vecteur $\Xi_{k+1}$ d'anticipation d'états à minimiser, de façon à obtenir des états anticipés les plus proches possibles d'états ciblés de valeur nulle. On reconnaît dans le deuxième terme du membre de droite le méta-vecteur $U_k$ d'anticipation de commandes à minimiser, de façon à obtenir des commandes anticipées les plus faibles possibles pour atteindre les états ciblés de valeur nulle.

La méta-matrice Q de pondération d'états anticipés comporte n·N lignes et n·N colonnes de diagonale confondue avec les diagonales de N matrices $Q_{k+i-1}$ de pondération d'états élémentaires comportant chacune n lignes et n colonnes, i variant de 1 à N. La diagonale de chaque matrice $Q_{k+i-1}$ de pondération d'états élémentaires comporte un coefficient de pondération pour chaque état élémentaire. Plus le coefficient de pondération associé à un état élémentaire est élevé, plus l'état élémentaire est minimisé dans l'optimisation quadratique associée au premier terme. Ainsi plus le coefficient de pondération est élevé, plus l'état élémentaire associé a d'importance à être minimisé. A priori toutes les matrices $Q_{k+i-1}$ de pondération d'états élémentaires sont identiques dans la mesure où il n'existe pas de raison à pondérer différemment les états élémentaires des états successifs. Cependant comme nous le voyons à présent dans un mode préféré de réalisation, il est intéressant pour la dernière matrice $Q_{k+N}$ de pondération d'états élémentaires d'avoir des coefficients différents des autres matrices.

Un premier mécanisme permettant d'assurer la stabilité du système dynamique, consiste à paramétrer préalablement en phase d'étude et d'essais, une matrice P de valeurs différentes de celles des coefficients des matrices $Q_{k+1}$ à $Q_{k+N-1}$, de sorte que pour le dernier état prédit à l'horizon N:

$$Q_{k+N} = P.$$

De façon à assurer qu'au-delà de l'horizon N, la fonction de coût J est décroissante, en d'autres termes qu'elle finira par converger, une pratique commune et de définir un coût d'accès comme une fonction de Lyapounov décroissante de manière comparable à celles décrites dans les documents US2002/0193920 ou US6560493.

Pour un système LTI (Linear Time Invariant), la matrice de pondération terminale P est choisie de façon à ce que la fonction de coût J soit équivalente à un coût d'horizon infini comme c'est le cas dans les contrôleurs LQR (Linear Quadratic Regulator) de régulation linéaire quadratique. La matrice P est obtenue par résolution d'une équation de Ricatti connue par exemple des documents cités au paragraphe précédent.

Dans le cas présent de l'invention, le système dynamique qui varie en fonction de la vitesse du véhicule, est de type LPV (Linear Parameter Varying). La pondération de coût terminal est alors calculée par résolution d'inégalités matricielles linéaires LMI (Linear Matrix Inequalities) déjà décrites par ailleurs, par exemple dans les documents EP2855238B1, US9535422B2, ou EP2855240B1.

La méta-matrice R de pondération de commandes anticipées comporte N lignes et N colonnes de diagonale confondue avec les diagonales de N matrices $R_{k+i}$ de pondération de commande élémentaire comportant chacune 1 ligne et 1 colonne, i variant de 1 à N. La diagonale de chaque matrice $R_{k+i}$ de pondération de commande élémentaire comporte un coefficient de pondération pour la commande anticipée $u_{k+i}$. Plus le coefficient de pondération associé à une commande élémentaire est élevé, plus la commande est minimisée dans l'optimisation quadratique associée au deuxième terme. Ainsi plus le coefficient de pondération est élevé, plus la commande élémentaire associée présente d'importance à être minimisée. A priori toutes les matrices $R_{k+i}$ de pondération de commandes élémentaires sont identiques dans la mesure où il n'existe pas de raison à pondérer différemment les commandes élémentaires des états successifs.

Le réglage des valeurs des coefficients des matrices $Q_{k+i-1}$ et $R_{k+i}$ en phase de mise au point par modélisation ou par essais sur piste du véhicule, permet d'ajuster le comportement du module contrôleur 3.

Dans la formule 125, l'optimisation agit sur le méta-vecteur de commandes $U_k$, qui constitue l'inconnue de l'équation ou plus exactement la grandeur à déterminer, le méta-vecteur d'états, quant à lui étant donné par la formule 124 qui le fait résulter des commandes, des courbures de la voie de circulation et du comportement mécanique du véhicule. En remplaçant dans la formule 125, le méta-vecteur d'état $\Xi_{k+1}$ par son expression donnée dans la formule 124, on obtient la formule 126 :

$$\mathcal{J}_1 = (\hat{\xi}_k^T A^T + U_k^T B^T + \Gamma_k^T G^T) Q (A \hat{\xi}_k + B U_k + G \Gamma_k) + U_k^T R U_k$$

En développant la formule 126, la première méta-fonction de coût peut s'écrire sous forme d'une somme de quatre expressions :

$$\mathcal{J}_1 = E_{xp1} + E_{xp2} + E_{xp3} + E_{xp4}$$

Dans laquelle la première expression $Exp_1$ ne dépend que du vecteur d'estimation $\hat{\xi}_k$ de l'état courant donnée par le module 2, du méta-vecteur $\Gamma_k$ de courbures de la voie donnée par le module 9, et ne dépend pas du méta-vecteur de commandes $U_k$ qui seul constitue la grandeur contrôlable d'optimisation :

$$E_{xp1} = \hat{\xi}_k^T A^T Q A \hat{\xi}_k + \hat{\xi}_k^T A^T Q G \Gamma_k + \Gamma_k^T G^T Q A \hat{\xi}_k + \Gamma_k^T G^T Q G \Gamma_k$$

La deuxième expression $Exp_2$ ne dépend que du vecteur d'estimation $\hat{\xi}_k$ de l'état courant et du méta-vecteur de commandes $U_k$ à l'ordre 1 :

$$E_{xp2} = \hat{\xi}_k^T A^T Q B U_k + U_k^T B^T Q A \hat{\xi}_k = 2 \hat{\xi}_k^T A^T Q B U_k$$

La troisième expression $Exp_3$ ne dépend que du méta-vecteur $\Gamma_k$ de courbures de la voie, et du méta-vecteur de commandes $U_k$ à l'ordre 1 :

$$E_{xp3} = U_k^T B^T Q G \Gamma_k + \Gamma_k^T G^T Q B U_k = 2 \Gamma_k^T G^T Q B U_k$$

La quatrième expression $Exp_4$ ne dépend que du méta-vecteur de commandes $U_k$ à l'ordre 2 :

$$E_{xp4} = U_k^T B^T Q B U_k + U_k^T R U_k = U_k^T (B^T Q B + R) U_k$$

On définit une méta-matrice H d'optimisation quadratique dynamique qui permet de réécrire la quatrième expression $Exp_4$ avec la formule 127 suivante :

$$E_{xp4} = U_k^T (B^T Q B + R) U_k = U_k^T (H) U_k$$

On note que la méta-matrice H=B$^T$QB+R d'optimisation quadratique dynamique fait intervenir par la méta-matrice R une hiérarchisation des commandes corrélée par la méta-matrice Q à une hiérarchisation des états. Les coefficients de la méta-matrice H d'optimisation quadratique dynamique sont des constantes.

On définit une méta-matrice h d'optimisation croisée dynamique qui permet de réécrire la somme de la deuxième Exp$_2$ et de la troisième Exp$_3$ expression avec la formule 127 suivante :

$$\text{E}_{\text{xp2}}+\text{E}_{\text{xp3}}=2(\hat{\xi}_k^T A^T +\Gamma_k^T G^T)Q\ B\ U_k=\ h\ U_k$$

On note que la méta-matrice $h=2(\hat{\xi}_k^T A^T+\Gamma_k^T G^T)QB$ d'optimisation croisée dynamique fait intervenir sous forme transposée dans ses coefficients, le vecteur d'estimation courante d'état $\hat{\xi}_k^T$ et le méta-vecteur de courbures $\Gamma_k^T$ qui sont variables au cours du temps. On rappelle que le vecteur d'estimation d'états $\hat{\xi}_k^T$ à l'instant courant k peut se voir remplacé par le vecteur d'état réel $\xi_k^T$ sur des véhicules dans lesquels ce dernier est accessible.

La première méta-fonction de coût peut alors se réécrire de la manière suivante :

$$\text{J}_1 = \text{E}_{\text{xp1}}+ \ U_k^T(H)U_k + \ h\ U_k$$

Comme la première expression Exp$_1$ ne dépend pas du méta-vecteur U$_k$ qui est la seule variable sur laquelle il est possible d'agir pour minimiser le coût, on peut définir une deuxième méta-fonction de coût $\text{J}_2$ par la formule 128 suivante :

$$\text{J}_2(U_k) = \ U_k^T(H)U_k + \ h\ U_k$$

On remarquera que les méta-fonctions de coût $\text{J}_1$ et $\text{J}_2$ ont les mêmes extrémums en relation avec le méta-vecteur U$_k$.

Le mode de réalisation illustré par la figure 3 comporte ici le même dispositif observateur 2 que celui illustré par la figure 2. L'homme du métier comprendra aisément que de nombreux autres dispositifs observateurs peuvent convenir, tant pour le mode de réalisation illustré par la figure 2 que pour celui illustré par la figure 3, pour autant que le dispositif observateur permet de générer un vecteur d'état estimé $\hat{\xi}_k$ courant à chaque instant k à partir d'une commande u$_k$ de contrôle latéral appliquée au véhicule au même instant k lorsqu'une estimation est nécessaire par manque d'accès aux états réels à l'instant courant k.

Dans le mode de réalisation préféré, illustré par la figure 3, le module 3 est remplacé par un module 13 qui optimise le méta-vecteur U$_k$ des commandes anticipées en exploitant la deuxième méta-fonction de coût $\text{J}_2$ définie ci-dessus par la formule 128. Par rapport à la première fonction de coût $\text{J}_1$ exploitée par le module 3, la deuxième méta-fonction de coût $\text{J}_2$ a pour avantage de ne plus faire intervenir qu'implicitement mais non explicitement le méta-vecteur d'état $\Xi_{k+1}$.

Le module 14 est remplacé par un module 19 qui comprend le même sous-module 8 et le même sous-module 10 pour recevoir respectivement le vecteur d'état estimé généré par le module 2 et les N courbures anticipées de courbes générées par le sous-module 9, mais qui ne comprend plus le sous-module 18. Un sous-module 16 reçoit la sortie du sous-module 8 additionnée à la sortie du sous-module 10 pour générer une valeur à l'instant k de la méta-matrice h d'optimisation croisée dynamique ou de sa transposée en multipliant la somme (A$\hat{\xi}_k$ +G$\Gamma_k$) par le produit matriciel 2B$^T$Q$^T$ de façon à permettre au module 13 d'obtenir directement ou indirectement la méta-matrice h d'optimisation croisée dynamique donnée par la formule 129 ci-dessous:

$$h=[2B^TQ^T(A\,\hat{\xi}_k +G\Gamma_k)]^T=2(\hat{\xi}_k^T A^T+\Gamma_k^T G^T)QB$$

Le deuxième mode de réalisation a pour avantage de découpler clairement, d'une part la fonction d'anticipation réalisée par le module 19 à partir d'une connaissance des courbures de la voie aux endroits où le véhicule est prévu de se trouver aux N instants k+1, k+i, k+N suivant l'instant k courant, et à partir de l'état estimé courant du véhicule par rapport à la voie, et d'autre part la fonction pure d'optimisation réalisée par le module 13.

Le module 13 utilise alors la deuxième méta-fonction pour générer le méta-vecteur optimal des commandes en utilisant l'un des nombreux algorithmes d'optimisations quadratiques connus, comme par exemple à titre purement illustratif et non limitatif, la méthode du gradient ou la méthode de Newton pour résoudre l'équation donnée par la formule 130 suivante :

$$ U_k^* = \underset{U_k}{\mathrm{argmin}}\, J_2(U_k) = \underset{U_k}{\mathrm{argmin}}[U_k^T \cdot H \cdot U_k + h \cdot U_k] $$

A chaque cycle de calcul, seule la commande $u_k$, première(s) composante(s) du méta-vecteur $U_k$ de rang k, est appliquée au véhicule. Les autres composantes peuvent être éliminées. On peut cependant optionnellement les garder, par exemple pour initialiser le cycle de calcul suivant de manière à converger plus rapidement vers la solution optimale, ou encore pour continuer à fonctionner sur un nombre limité de cycles de calcul postérieurs au cycle en cours, pour remédier à une perte momentanée de mesures ou d'autres informations comme celles fournissant les courbures de la voie.

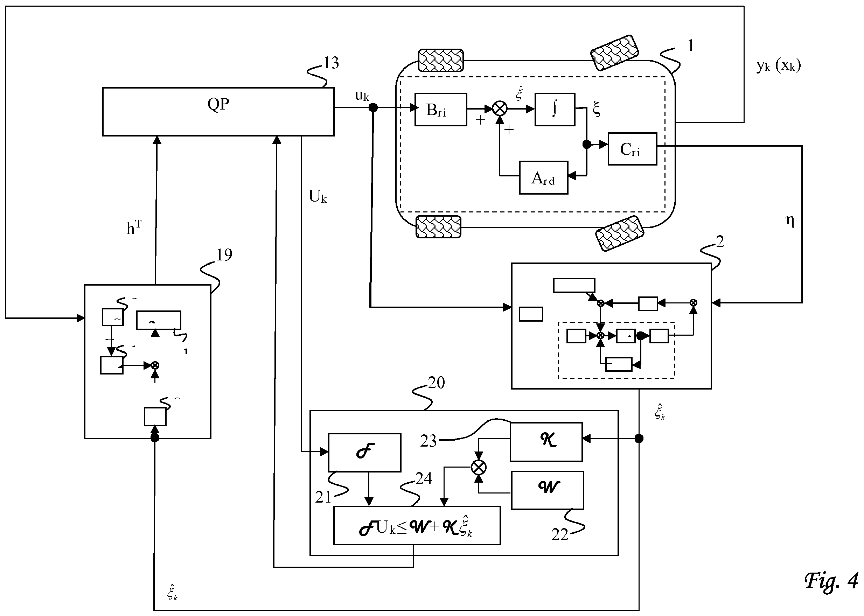

La figure 4 montre un module 20 recevant le méta-vecteur Uk pour définir les contraintes du système que la solution optimale doit respecter. De cette manière, le module 13 résout un problème d'optimisation quadratique avec des contraintes.

On peut utilement ajouter des contraintes sur les états ξ admissibles du système, sur les commandes u faisables et/ou sur les mesures η acceptables. De la sorte, on s'assure que les valeurs calculées de la commande actuelle et des commandes anticipées, sont optimales dans un univers des possibles, tant en termes de limites physiques du véhicule que de sécurité pour la circulation routière et plus particulièrement pour les passagers du véhicule, voire pour leur confort.

Dans un premier cas de contraintes portant sur les états du système, on peut vouloir que chaque état élémentaire, composante du vecteur d'état estimé $\hat{\xi}_k$ ou du vecteur d'état réel $\xi_k$ soit dans une plage de composantes de vecteur d'états $[\xi_{min}, \xi_{max}]$ donnée par un sous-module 22 du module 20. Si on souhaite que ces limites s'appliquent à tous les états successifs sur l'horizon de prédiction, on retranscrit les limites sur un méta-vecteur d'états $\Xi_{k+1}^{est}$, comprenant la succession des états donnés par le sous-module 4, soit en utilisant la formule 131 ci-dessous :

$$ \Xi_{k+1}^{est} = A\,\hat{\xi}_k + B\,U_k $$

Pour la borne supérieure :

$$ B\,U_k \le \begin{Bmatrix} \xi_{max} \\ \vdots \\ \xi_{max} \end{Bmatrix} - A\,\hat{\xi}_k $$

Pour la borne inférieure :

$$ B\,U_k \ge \begin{Bmatrix} \xi_{min} \\ \vdots \\ \xi_{min} \end{Bmatrix} - A\,\hat{\xi}_k $$

Ce qui peut s'écrire sous la forme de l'inégalité suivante:

$$\begin{bmatrix} \mathbf{B} \\ -\mathbf{B} \end{bmatrix} \mathbf{U}_k \le \begin{bmatrix} \begin{Bmatrix} \xi_{\max} \\ \vdots \\ \xi_{\max} \end{Bmatrix} \\ -\begin{Bmatrix} \xi_{\min} \\ \vdots \\ \xi_{\min} \end{Bmatrix} \end{bmatrix} + \begin{bmatrix} -\mathbf{A} \\ \mathbf{A} \end{bmatrix} \cdot \hat{\xi}_k$$

Ou encore en posant pour une limitation des valeurs d'état, les méta-matrices:

$$F_\xi = \begin{bmatrix} B \\ -B \end{bmatrix} \; ; \; W_\xi = \begin{bmatrix} \begin{Bmatrix} \xi_{\max} \\ \vdots \\ \xi_{\max} \end{Bmatrix} \\ -\begin{Bmatrix} \xi_{\min} \\ \vdots \\ \xi_{\min} \end{Bmatrix} \end{bmatrix} \text{et } K_\xi = \begin{bmatrix} -A \\ A \end{bmatrix}$$

Un sous-module 21 reçoit dans le module 20 le méta vecteur $U_k$ et dispose de la méta-matrice B pour générer le membre de gauche de l'inégalité précédente.

Un sous-module 23 reçoit dans le module 20 le vecteur d'états estimés ou réels selon le cas à l'instant k et dispose en temps réel de la méta-matrice A pour générer le membre de droite de l'inégalité précédente en association avec le sous-module 22.

Le premier cas de contraintes portant sur les états du système, peut s'obtenir en imposant à la valeur optimisée $U_k$ de vérifier la formule 132 ci-dessous:

$$F_\xi \, U_k \le \, W_\xi + K_\xi \hat{\xi}_k$$

L'inégalité de la formule 132 ci-dessus est hébergée dans un sous-module 24 recevant le membre de gauche défini par le méta-vecteur inconnu Uk, et le membre de droite égal à la somme des termes obtenus par le sous-module 22 et le sous-module 23, pour imposer au membre de gauche d'être inférieur au membre de droite. Autrement dit, le sous-module 21 permet de vérifier qu'une variation de l'état courant et des états prédits, corrélée à la commande courante recherchée et aux commandes prédites par la méta-matrice $F_\xi$ est inférieure à une distance qui sépare l'état courant et les états prédits des états minimaux et maximaux admissibles.

De manière plus générale, la méta-matrice $F_\xi$ est incluse dans une méta-matrice F du sous-module 21, la méta-matrice $W_\xi$ est incluse dans une méta-matrice W du sous-module 22, la méta-matrice $K_\xi$ est incluse dans une méta-matrice K du sous-module 23. Ainsi, l'inégalité gérée par le sous-module 24 s'écrit encore sous la forme :

$$F \, U_k \le \, W + K \, \hat{\xi}_k$$

Dans un deuxième cas de contraintes portant sur les commandes du système, on peut vouloir que chaque commande élémentaire, composante du méta-vecteur $U_k$ soit dans une plage de composantes de vecteur de commande $[u_{min}, u_{max}]$.

On pose alors pour une limitation des valeurs de commande, les méta-matrices:

$$F_u = \begin{bmatrix} I \\ -I \end{bmatrix} \ ; \ W_u = \begin{bmatrix} \begin{Bmatrix} u_{max} \\ \vdots \\ u_{max} \end{Bmatrix} \\ -\begin{Bmatrix} u_{min} \\ \vdots \\ u_{min} \end{Bmatrix} \end{bmatrix} \text{ et } K_u = \begin{bmatrix} 0 \end{bmatrix} \text{ pour désigner la matrice}$$

nulle.

Le deuxième cas de contraintes portant sur les commandes du système, peut s'obtenir en imposant à la valeur optimisée de vérifier la formule 133 ci-dessous:

$$F_u \ U_k \leq W_u + K_u \hat{\xi}_k$$

On peut inclure les méta-matrices $F_u$, $W_u$, $K_u$ respectivement dans les méta-matrices F, W, K avec ou sans les méta-matrices $F_\xi$, $W_\xi$, $K_\xi$ selon que l'on veut ou non satisfaire à la fois les contraintes sur les commandes et celles sur les états.

Dans un troisième cas de contraintes portant sur les mesures du système, on peut vouloir que chaque mesure élémentaire, composante du vecteur $\eta_k$ soit dans une plage de composantes de vecteur de commande [$\eta_{min}$, $\eta_{max}$].

Alors en posant pour une limitation des valeurs de mesure, les méta-matrices:

$$F_\eta = \begin{bmatrix} C \cdot B \\ -C \cdot B \end{bmatrix} \ ; \ W_\eta = \begin{bmatrix} \begin{Bmatrix} \eta_{max} \\ \vdots \\ \eta_{max} \end{Bmatrix} \\ -\begin{Bmatrix} \eta_{min} \\ \vdots \\ \eta_{min} \end{Bmatrix} \end{bmatrix} \text{ et } K_\eta = \begin{bmatrix} -C \cdot A \\ C \cdot A \end{bmatrix}$$

Le troisième cas de contraintes portant sur les mesures du système, peut s'obtenir en imposant à la valeur optimisée de vérifier la formule 134 ci-dessous:

$$F_\eta \ U_{k+1} \leq W_\eta + K_\eta \hat{\xi}_k$$

On peut inclure les méta-matrices $F_\eta$, $W_\eta$, $K_\eta$ respectivement dans les méta-matrices F, W, K avec ou sans les autres méta-matrices précédemment évoquées selon que l'on veut ou non satisfaire à la fois les contraintes sur les mesures et tout ou partie des autres contraintes.

Dans un quatrième cas de contraintes portant sur la stabilité et la faisabilité du contrôle prédictif de modèle, on peut vouloir que le dernier état élémentaire à l'horizon, composante du dernier vecteur d'états prédits $\hat{\xi}_{k+N}$, converge à l'intérieur d'un polytope convexe $\Omega$ qui est positif, invariant et robuste.

$$\Omega = \left\{ \xi \in \Re^n \middle| F_\Omega \xi \leq g_\Omega \right\}$$

Où $\Re^n$ désigne le produit cartésien de l'ensemble $\Re$ des nombres réel en dimension n correspondant à la quantité d'état élémentaires du vecteur d'états.

Le but ici est de s'assurer que le dernier vecteur d'état prédit $\hat{\xi}_{k+N}$ soit dans un polytope $\Omega$ défini de manière connue en soi (voir par exemple WO201678715A1) à constituer un ensemble invariant positif robuste. De la sorte, les états convergent asymptotiquement au-delà de l'horizon lorsque le dernier état prédit à l'horizon N, est dans le polytope $\Omega$.

Différemment de l'état de la technique divulgué dans le document WO201678715A1 qui vérifie en phase de conception si des solutions atteignent le polytope, le dispositif de l'invention cherche à imposer en temps réel à la solution d'atteindre le polytope.

La fonction $F_\Omega$ et $g_\Omega$ sont définies tant en termes de commande que de courbure et de vitesse au-delà de l'horizon N, en utilisant une méthode connue en soi comme par exemple celle du document mentionné ci-dessus.

Alors on pose par exemple pour une limitation des valeurs de mesure, les méta-matrices:

$$F_\eta = \begin{bmatrix} [0] \\ F_\Omega \cdot B \ (\text{derniers n elements}) \end{bmatrix} ; W_\eta = \begin{bmatrix} [0] \\ g_\Omega \end{bmatrix}$$

et

$$K_\eta = \begin{bmatrix} [0] \\ F_\Omega \cdot A \ (\text{derniers n elements}) \end{bmatrix}$$

## Revendications

1. Dispositif de contrôle en temps réel de trajectoire d'un véhicule (1) autonome comprenant un module (3, 13) de contrôle qui produit en temps réel à partir d'un vecteur d'états réel ou estimé ($\xi_k$, $\hat{\xi}_k$) à chaque instant k de suivi d'une voie par le véhicule (1) se déplaçant à une vitesse (v) actuelle, une première commande ($u_k$) de braquage pour stabiliser la trajectoire du véhicule par rapport à ladite voie, comprenant un module (14, 19) anticipateur qui génère une grandeur ($\Xi_{k+1}$,h) représentative d'un méta-vecteur ($\Gamma_k$) de perturbations pour chaque position prédite du véhicule (1) à des instants succédant en quantité donnée (N) à l'instant (k) courant et du vecteur d'états ($\xi_k$, $\hat{\xi}_k$) à l'instant (k) courant, et en ce que le module (3, 13) de contrôle produit la première commande ($u_k$) de braquage par optimisation quadratique d'une relation, **caractérisé en ce que** ladite relation est optimisée entre ladite grandeur ($\Xi_{k+1}$,h) représentative générée et un méta-vecteur ($U_k$) de commandes successives de braquage pour chaque position prédite du véhicule (1) auxdits instants succédant en quantité donnée (N) à l'instant (k) courant.

2. Dispositif de contrôle selon la revendication 1, **caractérisé en ce que** lesdites perturbations sont des courbures de la voie pour chaque position prédite du véhicule (1).

3. Dispositif de contrôle selon l'une des revendications 1 ou 2, **caractérisé en ce que** ladite grandeur ($\Xi_{k+1}$,h) représentative comporte pour chaque position prédite du véhicule (1) auxdits instants succédant en quantité donnée (N) à l'instant (k) courant, au moins un produit du vecteur d'états ($\xi_k$, $\hat{\xi}_k$) à l'instant (k) courant par une matrice numérique A(v) modélisant une relation dynamique du véhicule et élevée à une puissance égale à un rang de succession (i) de ladite position prédite.

4. Dispositif de contrôle selon l'une des revendications 1 à 3, **caractérisé en ce que** ladite grandeur ($\Xi_{k+1}$,h) représentative comporte pour chaque position prédite du véhicule (1) auxdits instants succédant en quantité donnée (N) à l'instant (k) courant, au moins un produit de facteurs comprenant d'une part une perturbation ($\gamma_{k+i}$) sur la voie à la position prédite, et d'autre part une matrice numérique A(v) modélisant une relation dynamique du véhicule et élevée à une puissance égale à un rang de succession (i) de ladite position prédite.

5. Dispositif de contrôle selon la revendication 2, **caractérisé en ce qu'**il comporte un appareil (15) combinant les propriétés d'une caméra optique et d'un radar pour fournir au moins une géométrie de l'écart latéral (y(x)) de ligne directrice de la voie sous forme d'un polynôme.

6. Dispositif de contrôle selon la revendication 5, **caractérisé en ce que** le module (14, 19) anticipateur comprend un sous-module (9) de calcul de courbure ($\gamma_{k+i}$) à partir de la géométrie (y(x)) de ligne directrice médiane de la voie au moyen de la formule :

$$\gamma_{k+i} = \frac{y''(x)}{\left(1 + [y'(x)]^2\right)^{3/2}} \, .$$

7. Dispositif de contrôle selon l'une des revendications précédentes, **caractérisé en ce que** la relation entre ladite grandeur ($\Xi_{k+1}$,h) représentative générée et le méta-vecteur ($U_k$) de commandes successives de braquage, comporte pour chaque produit quadratique d'un état anticipé $\xi_{k+i}$, une matrice de pondération ($Q_{k+i}$) d'états élémentaires et une matrice de pondération ($R_{k+i}$) de commande élémentaire.

8. Dispositif de contrôle selon la revendication 7, **caractérisé en ce que** la matrice de pondération ($Q_{k+N}$) d'états élémentaires pour le dernier état anticipé ($\xi_{k+N}$), comporte des coefficients particuliers **en ce qu'**ils sont associés à une fonction positive décroissante du type Lyapunov, de façon à favoriser une convergence de l'optimisation.

9. Dispositif de contrôle selon l'une des revendications précédentes, **caractérisé en ce qu'**il comprend un module (20) imposant à tout ou partie des commandes élémentaires ($u_{k+i}$) du méta-vecteur ($U_k$) de commandes successives de braquage, de respecter des contraintes de type comprenant au moins une borne supérieure sur les états, sur les commandes et/ou sur les mesures.

10. Dispositif de contrôle selon la revendication précédente, **caractérisé en ce que** les contraintes comprennent au moins une borne inférieure sur les états, sur les commandes et/ou sur les mesures.

11. Dispositif de contrôle selon l'une des revendications 9 ou 10, **caractérisé en ce que** le module (20) impose de plus des contraintes sur les commandes élémentaires ($u_{k+i}$) du méta-vecteur ($U_k$) de commandes successives de braquage, pour que le dernier vecteur d'état prédit ($\xi_{k+N}$) soit dans un polytope ($\Omega$) qui assure une convergence asymptotique au-delà de l'horizon (N) de prédiction.

## Patentansprüche

1. Vorrichtung zur Echtzeit-Fahrspurkontrolle eines autonomen Fahrzeugs (1), die ein Kontrollmodul (3, 13) enthält, das in Echtzeit ausgehend von einem realen oder geschätzten Zustandsvektor ($\xi_k$, $\hat{\xi}_k$) zu jedem Zeitpunkt k der Verfolgung einer Fahrbahn durch das Fahrzeug (1), das sich mit einer aktuellen Geschwindigkeit (v) bewegt, eine erste Einschlagsteuerung ($u_k$) erzeugt, um die Fahrspur des Fahrzeugs bezüglich der Fahrbahn zu stabilisieren, die ein Vorausschaumodul (14, 19) enthält, das eine für einen Meta-Vektor ($\Gamma_k$) von Störungen für jede vorhergesagte Position des Fahrzeugs (1) zu Zeitpunkten, die in bestimmter Menge (N) auf den aktuellen Zeitpunkt (k) folgen, und für den Zustandsvektor ($\xi_k$, $\hat{\xi}_k$) zum aktuellen Zeitpunkt (k) repräsentative Größe ($\Xi_{k+1}$, h) generiert, und dass das Kontrollmodul (3, 13) die erste Einschlagsteuerung ($u_k$) durch quadratische Optimierung einer Beziehung erzeugt, **dadurch gekennzeichnet, dass** die Beziehung zwischen der erzeugten repräsentativen Größe ($\Xi_{k+1}$, h) und einem Meta-Vektor ($U_k$) aufeinanderfolgender Einschlagsteuerungen für jede vorhergesagte Position des Fahrzeugs (1) zu den Zeitpunkten, die in bestimmter Menge (N) auf den aktuellen Zeitpunkt (k) folgen, optimiert wird.

2. Kontrollvorrichtung nach Anspruch 1, **dadurch gekennzeichnet, dass** die Störungen Krümmungen der Fahrbahn für jede vorhergesagte Position des Fahrzeugs (1) sind.

3. Kontrollvorrichtung nach einem der Ansprüche 1 oder 2, **dadurch gekennzeichnet, dass** die repräsentative Größe ($_{k+1}$, h) für jede vorhergesagte Position des Fahrzeugs (1) zu den in bestimmter Menge (N) auf den aktuellen Zeitpunkt (k) folgenden Zeitpunkten mindestens ein Produkt aus dem Zustandsvektor ($\xi_k$, $\hat{\xi}_k$) zum aktuellen Zeitpunkt (k) und einer digitalen Matrix A(v) aufweist, die eine dynamische Beziehung des Fahrzeugs modellisiert und in eine Potenz gleich einem Nachfolgerang (i) der vorhergesagten Position erhoben ist.

4. Kontrollvorrichtung nach einem der Ansprüche 1 bis 3, **dadurch gekennzeichnet, dass** die repräsentative Größe ($_{k+1}$, h) für jede vorhergesagte Position des Fahrzeugs (1) zu den in bestimmter Menge (N) auf den aktuellen Zeitpunkt (k) folgenden Zeitpunkten mindestens ein Produkt aus Faktoren aufweist, die einerseits eine Störung ($\gamma_{k+i}$) auf der Fahrbahn in der vorhergesagten Position und andererseits eine digitale Matrix A(v) aufweisen, die eine dynamische Beziehung des Fahrzeugs modellisiert und in eine Potenz gleich einem Nachfolgerang (i) der vorhergesagten Position erhoben ist.

5. Kontrollvorrichtung nach Anspruch 2, **dadurch gekennzeichnet, dass** sie ein Gerät (15) aufweist, das die Eigenschaften einer optischen Kamera und eines Radars kombiniert, um mindestens eine Geometrie der seitlichen Abweichung (y(x)) einer Leitlinie der Fahrbahn in Form eines Polynoms zu liefern.

6. Kontrollvorrichtung nach Anspruch 5, **dadurch gekennzeichnet, dass** das Vorausschaumodul (14, 19) ein Teilm-

odul (9) der Krümmungsberechnung ($\gamma_{k+i}$) ausgehend von der Geometrie (y(x)) einer mittleren Leitlinie der Fahrbahn mittels der Formel enthält:

$$\gamma_{k+i} = \frac{y''(x)}{(1+[y'(x)]^2)^{3/2}}.$$

**7.** Kontrollvorrichtung nach einem der vorhergehenden Ansprüche, **dadurch gekennzeichnet, dass** die Beziehung zwischen der generierten repräsentativen Größe ($\Xi_{k+1}$, h) und dem Meta-Vektor ($U_k$) aufeinanderfolgender Einschlagsteuerungen für jedes quadratische Produkt eines vorausgeschauten Zustands $\xi_{k+i}$ eine Gewichtungsmatrix ($Q_{k+i}$) von Elementarzuständen und eine Gewichtungsmatrix ($R_{k+i}$) einer Elementarsteuerung aufweist.

**8.** Kontrollvorrichtung nach Anspruch 7, **dadurch gekennzeichnet, dass** die Gewichtungsmatrix ($Q_{k+N}$) von Elementarzuständen für den letzten vorausgeschauten Zustand ($\xi_{k+N}$) insofern besondere Koeffizienten aufweist, als sie einer abnehmenden positiven Funktion des Typs Lyapunov zugeordnet sind, um eine Konvergenz der Optimierung zu begünstigen.

**9.** Kontrollvorrichtung nach einem der vorhergehenden Ansprüche, **dadurch gekennzeichnet, dass** sie ein Modul (20) enthält, das allen oder einem Teil der Elementarsteuerungen ($u_{k+i}$) des Meta-Vektors ($U_k$) von aufeinanderfolgenden Einschlagsteuerungen vorschreibt, Beschränkungen von der Art zu beachten, die mindestens eine Obergrenze bezüglich der Zustände, bezüglich der Steuerungen und/oder bezüglich der Messungen enthalten.

**10.** Kontrollvorrichtung nach dem vorhergehenden Anspruch, **dadurch gekennzeichnet, dass** die Beschränkungen mindestens eine Untergrenze bezüglich der Zustände, bezüglich der Steuerungen und/oder bezüglich der Messungen enthalten.

**11.** Kontrollvorrichtung nach einem der Ansprüche 9 oder 10, **dadurch gekennzeichnet, dass** das Modul (20) außerdem Beschränkungen der Elementarsteuerungen ($u_{k+i}$) des Meta-Vektors ($U_k$) von aufeinanderfolgenden Einschlagsteuerungen vorschreibt, damit der letzte vorhergesagte Zustandsvektor ($\xi_{k+N}$) sich in einem Polytop ($\Omega$) befindet, das eine asymptotische Konvergenz jenseits des Vorhersagehorizonts (N) gewährleistet.

**Claims**

**1.** Device for real-time control of trajectory of an autonomous vehicle (1) comprising a control module (3, 13) which produces in real time on the basis of a real or estimated vector of states ($\xi_k$, $\hat{\xi}_k$) at each instant k of following of a lane by the vehicle (1) moving at a current speed (v), a first turning command ($u_k$) to stabilize the trajectory of the vehicle with respect to said lane, comprising an anticipator module (14, 19) which generates a quantity ($\Xi_{k+1}$,h) representative of a meta-vector ($\Gamma_k$) of disturbances for each predicted position of the vehicle (1) at instants succeeding in given amount (N) the current instant (k) and of the vector of states ($\xi_k$, $\hat{\xi}_k$) at the current instant (k), and in that the control module (3, 13) produces the first turning command ($u_k$) by quadratic optimization of a relation, **characterized in that** said relation is optimized between said representative quantity ($\Xi_{k+1}$,h ) generated and a meta-vector ($U_k$) of successive turning commands for each predicted position of the vehicle (1) at said instants succeeding in given amount (N) the current instant (k).

**2.** Control device according to Claim 1, **characterized in that** said disturbances are curvatures of the lane for each predicted position of the vehicle (1).

**3.** Control device according to one of Claims 1 and 2, **characterized in that** said representative quantity ($\Xi_{k+1}$,h) comprises, for each predicted position of the vehicle (1) at said instants succeeding in given amount (N) the current instant (k), at least one product of the vector of states ($\xi_k$, $\hat{\xi}_k$) at the current instant (k) by a numerical matrix A(v) modeling a dynamic relation of the vehicle and raised to a power equal to a succession rank (i) of said predicted position.

**4.** Control device according to one of Claims 1 to 3, **characterized in that** said representative quantity ($\Xi_{k+1}$, h) comprises, for each predicted position of the vehicle (1) at said instants succeeding in given amount (N) the current instant (k), at least one product of factors comprising on the one hand a disturbance ($\gamma_{k+i}$) on the lane at the predicted position, and on the other hand a numerical matrix A(v) modeling a dynamic relation of the vehicle and raised to a

**20**

power equal to a succession rank (i) of said predicted position.

5. Control device according to Claim 2, **characterized in that** it comprises an apparatus (15) combining the properties of an optical camera and of a radar so as to provide at least one geometry of the lateral deviation (y(x)) of director line of the lane in the form of a polynomial.

6. Control device according to Claim 5, **characterized in that** the anticipator module (14, 19) comprises a sub-module (9) for calculating curvature ($\gamma_{k+i}$) on the basis of the geometry (y(x)) of median director line of the lane by means of the formula:

$$\gamma_{k+i} = \frac{y''(x)}{\left(1 + [y'(x)]^2\right)^{3/2}} \; .$$

7. Control device according to one of the preceding claims, **characterized in that** the relation between said representative quantity ($\Xi_{k+1}$, h) generated and the meta-vector ($U_k$) of successive turning commands comprises, for each quadratic product of an anticipated state $\xi_{k+i}$, an elementary states weighting matrix ($Q_{k+i}$) and an elementary command weighting matrix ($R_{k+i}$).

8. Control device according to Claim 7, **characterized in that** the elementary states weighting matrix ($Q_{k+N}$) for the last anticipated state ($\xi_{k+N}$) comprises coefficients which are particular **in that** they are associated with a decreasing positive function of the Lyapunov type, so as to favor a convergence of the optimization.

9. Control device according to one of the preceding claims, **characterized in that** it comprises a module (20) compelling all or some of the elementary commands ($u_{k+i}$) of the meta-vector ($U_k$) of successive turning commands to comply with constraints of type comprising at least one upper bound on the states, on the commands and/or on the measurements.

10. Control device according to the preceding claim, **characterized in that** the constraints comprise at least one lower bound on the states, on the commands and/or on the measurements.

11. Control device according to one of Claims 9 and 10, **characterized in that** the module (20) moreover imposes constraints on the elementary commands ($u_{k+i}$) of the meta-vector ($U_k$) of successive turning commands, so that the last state vector predicted ($\xi_{k+N}$) is in a polytope ($\Omega$) which ensures asymptotic convergence beyond the prediction horizon (N).

Fig. 1

Fig. 2

*Fig. 3*

Fig. 4

EP 3 589 533 B1

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1074903 B1
- US 8751089 B2
- WO 2014006327 A1
- FR 2925005
- WO 2012084465 A
- FR 1255068
- FR 1255188

- FR 12563339
- US 20020193920 A
- US 6560493 B
- EP 2855238 B1
- US 9535422 B2
- EP 2855240 B1
- WO 201678715 A1